# EUROPEAN PATENT SPECIFICATION

(11) **EP 4 468 003 B1**
(45) Date of publication and mention of the grant of the patent: **18.03.2026**
(21) Application number: 23831869.5
(22) Date of filing: 27.06.2023
(51) Int. Cl.: G01R 31/396, G01R 31/392, G01R 31/389, G01R 31/385, G01R 19/165, G01R 31/36, G08B 21/18, G01R 31/3835, G01R 31/367, G01R 31/3828, G01R 31/3842

(54) **APPARATUS AND METHOD FOR DIAGNOSING BATTERY**
BATTERIEDIAGNOSEVORRICHTUNG UND -VERFAHREN
DISPOSITIF ET PROCÉDÉ DE DIAGNOSTIC DE BATTERIE

(30) Priority: 28.06.2022 KR 20220079279; 26.06.2023 KR 20230082222
(43) Date of publication of application: 27.11.2024
(73) Proprietor: LG Energy Solution, Ltd., Seoul 07335 (KR)
(72) Inventor: BAE, Yoon-Jung, Daejeon 34122 (KR); WOO, Kyung-Hwa, Daejeon 34122 (KR)
(74) Representative: Goddar, Heinz J.
(86) International application number: PCT/KR2023/008957
(87) International publication number: WO 2024/005510

(56) References cited:
- CN-A- 111 751 741
- JP-A- 2012 178 953
- JP-A- H09 134 742
- JP-B2- 6 660 562
- KR-A- 20160 080 802
- KR-A- 20210 046 548
- KR-A- 20220 015 799
- KR-A- 20220 041 635

## Description

### TECHNICAL FIELD

The present application claims priority to Korean Patent Application No. 10-2022-0079279 filed on June 28, 2022 in the Republic of Korea and Korean Patent Application No. 10-2023-0082222 filed on June 26, 2023 in the Republic of Korea.

The present disclosure relates to an apparatus and method for diagnosing a battery, and more particularly, to an apparatus and method for diagnosing a state of a battery that can diagnose the state of a battery in a non-destructive manner.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

These batteries can degrade as charging and discharging continues. For example, the generation of gas inside the battery may reduce the electron transport capacity within the electrode, resulting in negative electrode degrade imbalance.

Additionally, the internal gas of the battery may cause the battery housing to swell and the sealing portion of the battery to vent. In this case, the internal gas of the battery may be released, which may cause a fire in the battery.

In other words, if the state of the battery is not quickly diagnosed, unexpected problems such as performance degradation, fire, and explosion may occur.

The document CN 111 751 741 A discloses diagnosing a battery wherein a second voltage/resistance profile is used as a reference profile and compared to an initial voltage/resistance profile.

### DISCLOSURE

### Technical Problem

The present disclosure is designed to solve the problems of the related art, and therefore the present disclosure is directed to providing an apparatus and method for diagnosing a battery that can diagnose the state of a battery in a non-destructive manner through profile analysis.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure comprises a data obtaining unit configured to obtain a resistance value and a voltage value of a battery; a profile generating unit configured to generate a profile representing a correspondence relationship between the resistance value and the voltage value of the battery obtained by the data obtaining unit; and a control unit configured to set a criterion range in the profile received from the profile generating unit and diagnose whether an abnormality has occurred in the battery based on the result of comparing the resistance value of the battery and the criterion range.

In the apparatus for diagnosing a battery according to one aspect of the present disclosure, the control unit may be configured to set a criterion line representing a change rate of the resistance value with respect to the voltage value in the profile and set the criterion range based on the criterion line.

In the apparatus for diagnosing a battery according to one aspect of the present disclosure, the control unit may be configured to set the criterion range within a predetermined threshold value from the criterion line.

In the apparatus for diagnosing a battery according to one aspect of the present disclosure, the control unit may be configured to set the criterion line excluding a target resistance value and a target voltage value most recently included in the profile.

In the apparatus for diagnosing a battery according to one aspect of the present disclosure, the data obtaining unit may be configured to obtain the voltage value and the resistance value at a time point when the battery remains in an idle state for a predetermined time after discharge ends, and the profile generating unit may be configured to generate the profile when the voltage value belongs to a preset voltage section.

In the apparatus for diagnosing a battery according to one aspect of the present disclosure, the voltage section may be set as a section where a reduction rate of resistance exceeds a preset threshold value as the voltage increases.

In the apparatus for diagnosing a battery according to one aspect of the present disclosure, the profile generating unit may be configured to update the profile whenever the data obtaining unit obtains the resistance value and the voltage value, and the control unit may be configured to set the criterion range whenever the profile is updated.

In the apparatus for diagnosing a battery according to one aspect of the present disclosure, the control unit may be configured to diagnose whether an abnormality has occurred in the battery based on whether the resistance value is outside the criterion range.

In the apparatus for diagnosing a battery according to one aspect of the present disclosure, the control unit may be configured to diagnose that no abnormality has occurred in the battery when the resistance value is within the criterion range, and to diagnose that an abnormality has occurred in the battery when the resistance value is outside the criterion range.

In the apparatus for diagnosing a battery according to one aspect of the present disclosure, when it is diagnosed that an abnormality has occurred in the battery, the control unit may be configured to generate an alarm in response to the abnormality.

A battery pack according to another aspect of the present disclosure comprises the apparatus for diagnosing a battery according to an aspect of the present disclosure.

A method for diagnosing a battery according to still another aspect of the present disclosure comprises: battery information obtaining step of obtaining a resistance value and a voltage value of a battery; a profile generating step of generating a profile representing a correspondence relationship between the resistance value and the voltage value of the battery obtained in the battery information obtaining step; a criterion range setting step of setting a criterion range in the profile generated in the profile generating step; and a battery diagnosing step of diagnosing whether an abnormality has occurred in the battery based on the result of comparing the resistance value of the battery and the criterion range.

### Advantageous Effects

According to one aspect of the present disclosure, the state of the battery can be diagnosed in a non-destructive manner through profile analysis. In particular, whether an abnormality in the battery has occurred can be specifically diagnosed using the resistance value and potential value of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a profile according to an embodiment of the present disclosure.
FIG. 3 is a diagram schematically showing a criterion line according to an embodiment of the present disclosure.
FIG. 4 is a diagram schematically showing a criterion range according to an embodiment of the present disclosure.
FIG. 5 is a diagram schematically showing another profile according to an embodiment of the present disclosure.
FIG. 6 is a diagram schematically showing still another profile according to an embodiment of the present disclosure.
FIG. 7 is a diagram showing an exemplary configuration of a battery pack according to another embodiment of the present disclosure.
FIG. 8 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other modifications could be made thereto without departing from the scope of the disclosure as defined by the claims.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

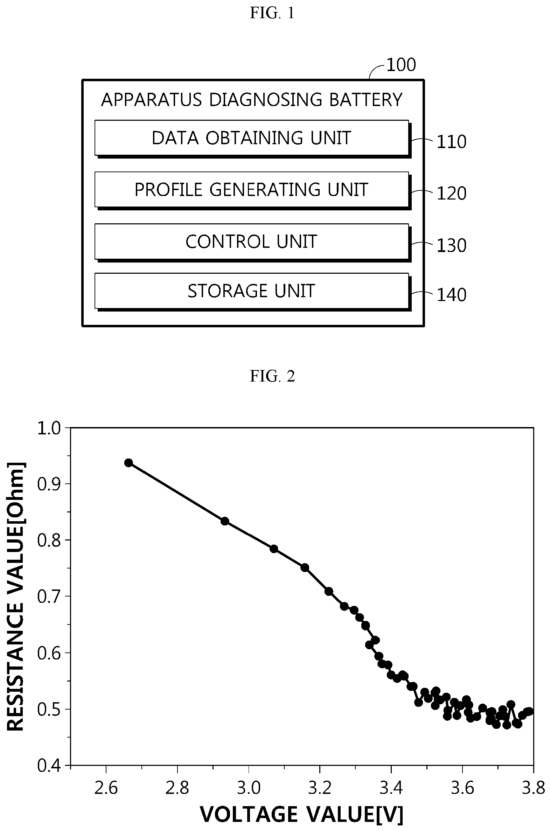

FIG. 1 is a diagram schematically showing an apparatus 100 for diagnosing a battery according to an embodiment of the present disclosure.

Referring to FIG. 1, the apparatus 100 for diagnosing a battery according to an embodiment of the present disclosure may include a data obtaining unit 110, a profile generating unit 120, and a control unit 130.

The data obtaining unit 110 can obtain the resistance value and voltage value of the battery.

Here, the battery refers to an independent cell that has a negative terminal and a positive terminal and is physically separable. As an example, one lithium-ion cell or one lithium polymer cell may be considered as a battery. Additionally, the battery may mean a battery module in which a plurality of cells are connected in series and/or parallel. Additionally, the battery may refer to a battery pack 1 in which a plurality of battery modules are connected in series and/or parallel. Below, for convenience of explanation, the battery is explained as meaning one independent cell.

For example, the data obtaining unit 110 can obtain battery information about the voltage value and resistance value of the battery in real time. As another example, the data obtaining unit 110 may periodically and/or aperiodically obtain battery information about the voltage value and resistance value of the battery.

Depending on the embodiment, the data obtaining unit 110 may obtain battery information including the resistance value and voltage value measured through a voltage sensing line connected to the positive electrode and negative electrode of the battery. Additionally, the data obtaining unit 110 may be connected to a current sensor that measures the current of the battery. Also, the data obtaining unit 110 can obtain battery information from the current sensor through the current sensing line. The data obtaining unit 110 can obtain the resistance value and voltage value of the battery using information included in the battery information.

Depending on the embodiment, the data obtaining unit 110 may be configured to communicate with the outside. The data obtaining unit 110 can receive battery information including the voltage value and resistance value of the battery from the outside using communication.

In an embodiment, the data obtaining unit 110 may obtain the voltage value and resistance value at a time point when the battery remains in the idle state for a predetermined time after discharge ends. That is, the data obtaining unit 110 can obtain the voltage value and resistance value of the battery at a time point after a predetermined period of time while maintaining an idle state from the time point when discharge of the battery ends.

The profile generating unit 120 and the data obtaining unit 110 may be connected wired and/or wirelessly to communicate with each other. Additionally, the profile generating unit 120 may receive battery information including the resistance value and voltage value from the data obtaining unit 110 through a wired line and/or a wireless communication network.

The profile generating unit 120 can generate a profile using the resistance value and voltage value of the battery obtained by the data obtaining unit 110. Here, the profile may represent the correspondence relationship between the resistance value and voltage value of the battery.

For example, the profile can be expressed as an X-Y two-dimensional graph when X is set to the voltage value of the battery and Y is set to the resistance value of the battery. It will be described in detail with reference to FIG. 2.

FIG. 2 is a diagram schematically showing a profile according to an embodiment of the present disclosure. FIG. 2 shows an X-Y two-dimensional graph in which X is set to the voltage value of the battery and Y is set to the resistance value of the battery.

At least one of the voltage value and resistance value on the profile generated by the profile generating unit 120 may be a relative value. For example, at least one of the voltage value and the resistance value may be a normalized value.

For example, in the embodiment of FIG. 2, the X-axis is marked with an absolute voltage value, but the Y-axis is marked with a normalized relative resistance value.

In an embodiment, the profile generating unit 120 can generate a profile if the voltage value belongs to a preset voltage section. The voltage section can be set based on a specific voltage value or based on a resistance reduction rate.

One embodiment of the voltage section is described. The voltage section can be set under the condition where the reduction rate of resistance exceeds a preset threshold value as the voltage increases. In this case, the profile generating unit 120 can generate a profile if the reduction rate of resistance belongs to a section that exceeds the preset threshold value as the voltage increases.

Referring to FIG. 2, since the resistance decreases rapidly as the voltage increases in the section where the voltage value is 3.5 V or less, the profile generating unit 120 can generate a profile if the voltage value belongs to the section of 3.5 V or less.

For example, in the embodiment of FIG. 2, the resistance reduction rate in the voltage section where the voltage value is greater than 3.5 V may be less than or equal to the preset threshold value. Here, the resistance reduction rate is the change rate of resistance with respect to voltage, and refers to the rate at which resistance decreases as the voltage increases. That is, in the voltage section exceeding 3.5 V, the rate at which resistance decreases as voltage increases is less than or equal to the threshold value, and in the voltage section of 3.5 V or less, the rate at which resistance decreases as voltage increases may exceed the threshold value. Therefore, the profile generating unit 120 can generate a profile for a voltage section of 3.5 V or less.

Another embodiment of the voltage section is described. The voltage section may be set based on a preset criterion voltage value for the criterion battery. Specifically, a criterion profile representing the correspondence relationship between criterion voltage value and criterion resistance value may be prepared in advance. The resistance value obtained by adding a predetermined resistance value to the minimum resistance value in the criterion profile can be determined as the target resistance value. For example, the predetermined resistance value may be set to a resistance value of 0.1 (Ω) or less. Preferably, the predetermined resistance value may be preset to a resistance value of 0.05 (Ω) or less.

For example, if the minimum resistance value is LR (Ω) and the predetermined resistance value is 0.05 (Ω), the target resistance value is LR + 0.05 (Ω).

Also, the voltage value corresponding to the target resistance value can be set as the criterion voltage value. Here, when there is a plurality of voltage values corresponding to the target resistance value, the lowest voltage value among the plurality of voltage values may be set as the criterion voltage value. For example, in the embodiment of FIG. 2, the criterion voltage value may be preset to 3.5 V. Therefore, the profile generating unit 120 can generate a profile for a voltage section of 3.5 V or less.

Another embodiment of the voltage section is described. The voltage section may be set based on the voltage profile and differential profile of the criterion battery. Here, the voltage profile is a profile that represents the correspondence relationship between the voltage (V) and capacity (Q) of the criterion battery. For example, the voltage profile can be expressed as a two-dimensional graph with the x-axis set to capacity (Q) and the y-axis set to voltage (V). Also, the differential profile is a profile that represents the correspondence relationship between the differential voltage (dV/dQ) and capacity (Q) of the criterion battery. For example, the differential profile is the first derivative of voltage profile. In other words, the differential profile can be expressed as a two-dimensional graph in which the x-axis is set to capacity (Q) and the y-axis is set to differential voltage (dV/dQ) obtained by differentiating the voltage (V) with respect to capacity (Q).

Specifically, the voltage section may be set to a section excluding the voltage section corresponding to the negative electrode flat section, where the influence of the negative electrode of the battery is minimized, among the entire voltage section. That is, the voltage section may be set to a section less than or equal to the criterion voltage value corresponding to the starting capacity of the negative electrode flat section among the entire voltage section.

Hereinafter, the capacity is a normalized value and is described as 0 to 1. The differential profile may include a negative electrode flat section that is less affected by the negative electrode. For example, the differential profile may include a plurality of peaks (points with an upwardly convex shape). Among these plurality of peaks, the capacity (Q) belongs to the capacity section of 0.4 to 1, and the peak with the largest differential voltage (dV/dQ) (hereinafter, a target peak) may be included. If the capacity of the target peak is Qt, the capacity Qt of the target peak may be the starting capacity of the negative electrode flat section. That is, the capacity section with a capacity (Q) of Qt to 1 may be a negative electrode flat section. Also, the voltage value Vt corresponding to the capacity Qt in the voltage profile can be set as the criterion voltage value. Therefore, among the entire voltage section, a section less than or equal to the criterion voltage value Vt can be set as the voltage section. The control unit 130 can set a criterion range in the profile received from the profile generating unit 120. The criterion range may mean the range of the resistance value indicating that the change rate of the resistance value with respect to the voltage value of the battery is normal. The method to set the criterion range will be described later.

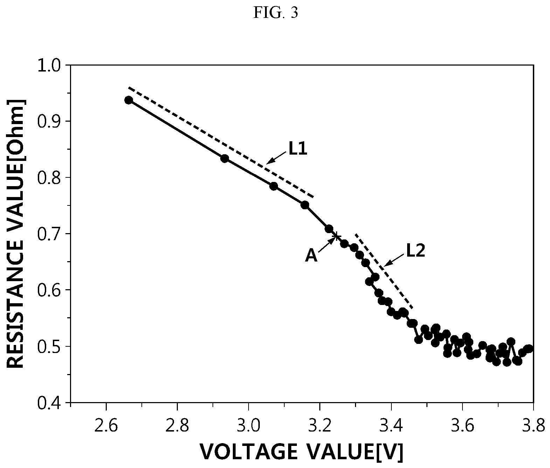

The control unit 130 can diagnose whether an abnormality has occurred in the battery based on the result of comparing the resistance value of the battery and the criterion range. This will be described later with reference to FIG. 3.

The apparatus 100 for diagnosing a battery according to an embodiment of the present disclosure can specifically diagnose a battery abnormality by comparing the resistance value and criterion range of the battery.

The apparatus 100 for diagnosing a battery according to an embodiment of the present disclosure can accurately diagnose the state of the battery by generating a profile using the voltage value and resistance value measured in real time.

Meanwhile, the data obtaining unit 110, the profile generating unit 120 and the control unit 130 provided in the apparatus 100 for diagnosing a battery may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the data obtaining unit 110, the profile generating unit 120 and the control unit 130 may be implemented as a set of program modules. At this time, the program module may be stored in a memory and executed by the data obtaining unit 110, the profile generating unit 120 and the control unit 130. The memory may be located inside or out of the data obtaining unit 110, the profile generating unit 120 and the control unit 130 and may be connected to the data obtaining unit 110, the profile generating unit 120 and the control unit 130 by various well-known means.

Additionally, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its type as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

Below, the criterion range is explained in detail. The criterion range may mean a range indicating that the change rate of the resistance value of the battery is normal. It will be described in detail with reference to FIG. 3.

FIG. 3 is a diagram schematically showing a criterion line according to an embodiment of the present disclosure. FIG. 3 shows the criterion line on an X-Y two-dimensional graph where X is set to the voltage value of the battery and Y is set to the resistance value of the battery.

In an embodiment, the control unit 130 may set a criterion line indicating the change rate of the resistance value with respect to the voltage value in the profile. For example, the control unit 130 may set a criterion line by approximating a curve connecting each resistance value in the profile in which resistance values for voltage values are displayed.

In an embodiment, the plurality of criterion lines can be set in one profile according to the change rate of resistance value. For example, the control unit 130 can set a plurality of criterion lines in one profile based on a point where the change rate of resistance value changes rapidly.

Referring to FIG. 3, the control unit 130 can set two criterion lines based on the point A where the change rate of the resistance value changes rapidly. The control unit 130 can generate a first criterion line L1 in the section of A or less and generate a second criterion line L2 in the section of A or more based on the point A where the change rate of resistance value changes rapidly.

Although the embodiment of FIG. 3 shows that the first criterion line L1 and the second criterion line L2 are located in the +Y axis direction from the profile, the first criterion line L1 and the second criterion line L2 may overlap the profile. For example, in the embodiment of FIG. 3, the first criterion line L1 may move in the -Y axis direction and overlap with the section of A or less of the profile. Additionally, the second criterion line L2 can also move in the -Y axis direction and overlap with the section of A or more. Specifically, the criterion line can be derived as a linear relationship for the points included in the corresponding section (e.g., the section of A or less or the section of A or more). Accordingly, the criterion line may overlap with the profile, and the embodiment of FIG. 3 shows the criterion line and the profile separately for convenience of explanation. That is, the drawings of the present disclosure (FIGS. 3 to 6) show that the profile is spaced apart from the first criterion line L1 and the second criterion line L2, but it should be noted that this is for convenience of explanation.

Since the control unit 130 sets each criterion line according to the change rate of the resistance value, a resistance abnormality of the battery can be determined for each voltage, so a battery abnormality can be more accurately diagnosed.

In an embodiment, the control unit 130 can set the criterion line excluding the target resistance value and the target voltage value. The target resistance value and the target voltage value may mean the resistance value and the voltage value most recently included in the profile.

Since the control unit 130 sets the criterion line excluding the target resistance value and the target voltage value, it is possible to accurately diagnose a battery abnormality by comparing the target resistance value with the criterion line in real time.

Here, the criterion line can be updated whenever the voltage value and the resistance value of the battery are measured. For example, it is assumed that at the nth time point, the nth resistance value is the target resistance value and the nth voltage value is the target voltage value. At the nth time point, a criterion line may be set based on the first to n-1th resistance values and the first to n-1th voltage values. Thereafter, at the n+1th time point, the n+1th resistance value may be determined as the target resistance value, and the n+1th voltage value may be determined as the target voltage value. In this case, the criterion line can be updated based on the first to nth resistance values and the first to nth voltage values.

In other words, the apparatus 100 for diagnosing a battery has an advantage of diagnosing the state of the battery more accurately by updating the criterion line by reflecting the latest state information of the battery.

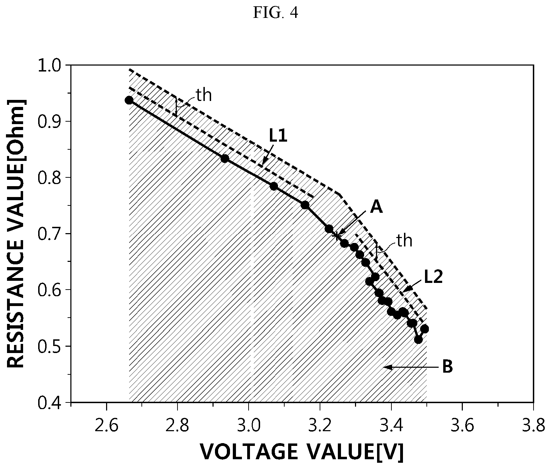

The control unit 130 can set the criterion range based on the criterion line. This will be explained with reference to FIG. 4.

FIG. 4 is a diagram schematically showing a criterion range according to an embodiment of the present disclosure. In FIG. 4, the criterion range is shown in an X-Y two-dimensional graph where X is set to the voltage value of the battery and Y is set to the resistance value of the battery.

In an embodiment, the control unit 130 may set a criterion range based on the criterion line. For example, control unit 130 can set the criterion range to be within a predetermined threshold value from the criterion line.

Referring to FIG. 4, the control unit 130 may set the criterion range (B) within a predetermined threshold value (th) from the criterion line L2.

Here, the threshold value (th) is a value added to set the criterion range from the criterion line. In other words, the threshold value (th) is a criterion value that determines the normal margin section for the resistance value. In other words, the section within the threshold value (th) from the criterion line is set as the criterion range (B) that can diagnose the battery as normal.

For example, the threshold value (th) may be preset to a resistance value of 1 (Ω) or less. Preferably, the threshold value (th) can be preset to a resistance value of 0.5 (Ω) or less.

For example, the threshold value (th) can be determined as an optimal value through experiments using batteries in various states. As another example, the threshold value (th) may be set considering the measurement error for the voltage value. In other words, the measured voltage value may include measurement error due to noise. Since the voltage measurement error affects the calculated resistance value, the threshold value (th) can be set considering this voltage measurement error. In other words, the threshold value (th) can be set to prevent the state of the battery from being misdiagnosed due to voltage measurement error.

Since the control unit 130 sets the criterion range to be within a predetermined threshold value from the criterion line, it is possible to prevent abnormal diagnosis due to minor errors occurring in the process of obtaining the resistance value and the voltage value of the battery.

In an embodiment, the control unit 130 may set a criterion range based on the plurality of criterion lines. For example, the control unit 130 may set a criterion range based on a plurality of criterion lines set for each section in which the change rate of resistance value changes rapidly.

Referring to FIG. 4, the criterion range set based on the plurality of criterion lines indicated based on the point (A) where the change rate of the resistance value changes rapidly is shown. The control unit 130 may set the range of the threshold value (th) or less from the first criterion line L1 as the criterion range in the section where the resistance value is A or lower, and set the range of the threshold value (th) or less from the second criterion line L2 as the criterion range in the section where the resistance value is A or higher.

Since the control unit 130 sets the criterion range based on different criterion lines set based on the point (A) where the change rate of the resistance value changes rapidly, an abnormality can be more accurately diagnosed according to the resistance value of the battery.

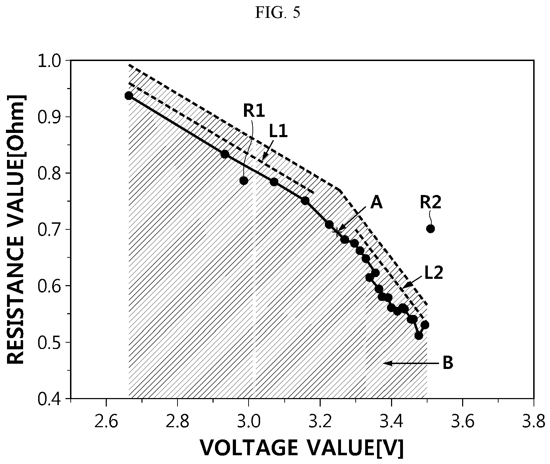

Hereinafter, a configuration in which the control unit 130 determines whether an abnormality has occurred in the battery using a criterion range will be described with reference to FIG. 5.

FIG. 5 is a diagram schematically showing another profile according to an embodiment. FIG. 5 shows an X-Y two-dimensional graph in which X is set to the voltage value of the battery and Y is set to the resistance value of the battery.

In an embodiment, the control unit 130 can diagnose whether an abnormality has occurred in the battery based on whether the voltage value belongs to the voltage section and whether the resistance value corresponding to the voltage value is outside the criterion range.

In one embodiment, when it is diagnosed that an abnormality has occurred in the battery, the control unit 130 may generate an alarm corresponding to the abnormality.

Referring to FIG. 5, the control unit 130 can diagnose that an abnormality has occurred in the battery depending on whether the resistance value is outside the B section, which is the criterion range.

For example, the control unit 130 can diagnose that no abnormality has occurred in the battery if the resistance value falls within the criterion range. Conversely, the control unit 130 can diagnose that an abnormality has occurred in the battery when the resistance value is outside the criterion range. Here, the voltage value corresponding to the resistance value may belong to the voltage section.

Referring to FIG. 5, the control unit 130 can diagnose that no abnormality has occurred in the battery because the first resistance value (R1) belongs to the B section, which is the criterion range.

However, since the second resistance value (R2) is outside the B section, which is the criterion range, the control unit 130 can diagnose that an abnormality has occurred in the battery.

By diagnosing an abnormality using the result of the control unit 130 comparing the resistance value with the criterion range, the state of the battery can be diagnosed in a non-destructive manner.

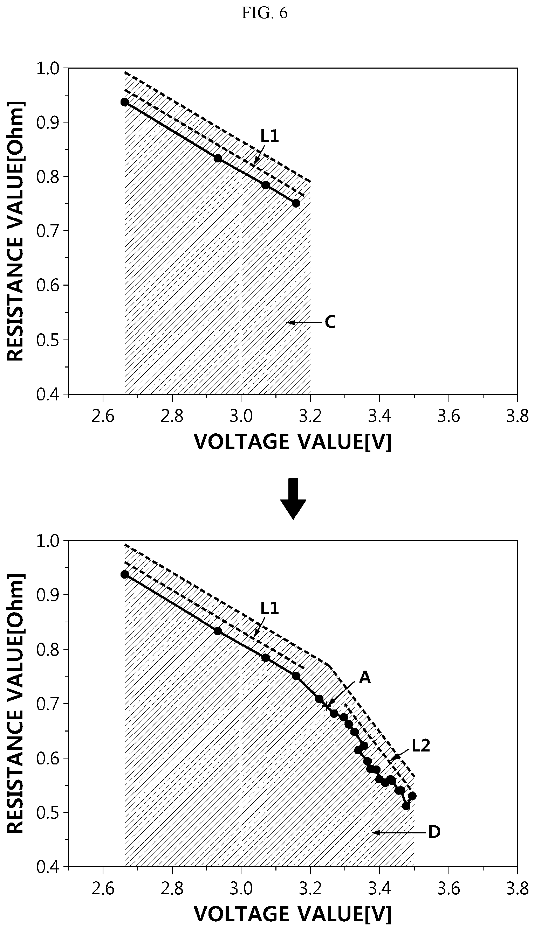

FIG. 6 is a diagram schematically showing still another profile according to an embodiment of the present disclosure. Specifically, FIG. 6 shows a profile that is updated whenever the data obtaining unit 110 obtains a resistance value and a voltage value.

In an embodiment, the profile generating unit 120 may update the profile whenever the data obtaining unit 110 obtains a resistance value and a voltage value. For example, the profile generating unit 120 may update the profile whenever the data obtaining unit 110 obtains a resistance value and a voltage value, if the obtained voltage value belongs to the preset voltage section. The voltage section can be set based on a specific voltage value or based on a resistance reduction rate.

For example, the voltage section may be set under the condition that it is a section in which the reduction rate of resistance exceeds the preset threshold value as the voltage increases. In this case, the profile generating unit 120 can generate a profile if the voltage section belongs to a section in which the reduction rate of resistance exceeds the preset threshold value as the voltage increases.

Referring to FIG. 6, since the resistance rapidly decreases as the voltage increases in the section where the voltage value is 3.5 V or less, the profile generating unit 120 can update the profile in the section where the obtained voltage value is 3.5 V or less.

In an embodiment, the control unit 130 can set the criterion range whenever the profile is updated. For example, the control unit 130 may set a criterion line whenever the profile is updated and set a criterion range based on the set criterion line. Setting the criterion line has been described above, so its explanation will be omitted.

Referring to FIG. 6, it can be seen that the control unit 130 newly sets the criterion range from C to D according to the updated profile.

The control unit 130 may diagnose an abnormality according to the resistance value in real time by updating the profile in real time and newly setting a new criterion range based on the updated profile.

The apparatus 100 for diagnosing a battery according to the present disclosure can be applied to the BMS (Battery Management System). In other words, the BMS according to the present disclosure may include the above-described apparatus 100 for diagnosing a battery. In this configuration, at least some of the components of the apparatus 100 for diagnosing a battery may be implemented by supplementing or adding functions of components included in a conventional BMS. For example, the data obtaining unit 110, the profile generating unit 120, the control unit 130 and the storage unit 140 of the apparatus 100 for diagnosing a battery may be implemented as components of a BMS.

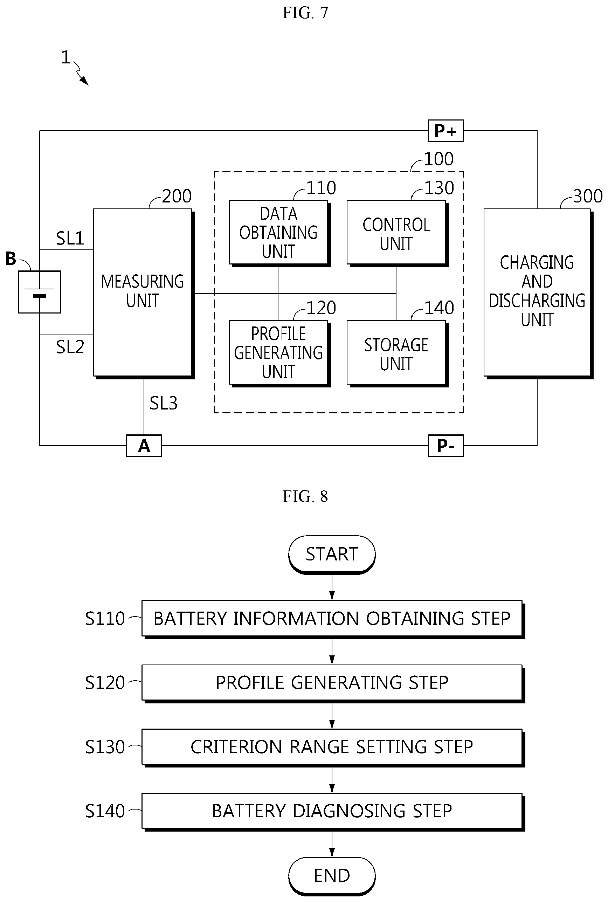

FIG. 7 is a diagram showing an exemplary configuration of a battery pack 1 including the apparatus 100 for diagnosing a battery according to another embodiment of the present disclosure.

The apparatus 100 for diagnosing a battery according to the present disclosure may be provided in a battery pack 1. That is, the battery pack 1 according to the present disclosure may include the above-described apparatus 100 for diagnosing a battery, a measuring unit 200, a charging and discharging unit 300, and one or more battery cells. In addition, the battery pack 1 may further include electrical equipment (relays, fuses, etc.) and a case.

The positive electrode terminal of the battery B may be connected to the positive electrode terminal P+ of the battery pack 1, and the negative electrode terminal of the battery B may be connected to the negative electrode terminal P- of the battery pack 1.

A measuring unit 200 may be connected to a first sensing line SL1, a second sensing line SL2, and a third sensing line SL3. Specifically, the measuring unit 200 may be connected to a positive electrode terminal of the battery B through the first sensing line SL1, and may be connected to a negative electrode terminal of the battery B through the second sensing line SL2. The measuring unit 200 may measure the voltage of the battery B based on the voltage measured at each of the first sensing line SL1 and the second sensing line SL2.

In addition, the measuring unit 200 may be connected to an ampere meter A through the third sensing line SL3. For example, the ampere meter A may be an ammeter or a shunt resistor capable of measuring the charging current and the discharging current of the battery B. The measuring unit 200 may calculate the charge amount by measuring the charging current of the battery B through the third sensing line SL3. Also, the measuring unit 200 may calculate the discharge amount by measuring the discharge current of the battery B through the third sensing line SL3.

One end of the charging and discharging unit 300 may be connected to the positive electrode terminal P+ of the battery pack 1, and the other end may be connected to the negative electrode terminal P- of the battery pack 1. Therefore, the positive electrode terminal of the battery B, the positive electrode terminal P+ of the battery pack 1, the charging and discharging unit 300, the negative electrode terminal P- of the battery pack 1, and the negative electrode terminal of the battery B may be electrically connected.

FIG. 8 is a diagram schematically showing a method for diagnosing a battery according to still another embodiment of the present disclosure.

Preferably, each step of the method for diagnosing a battery may be performed by the apparatus 100 for diagnosing a battery. Hereinafter, contents overlapping with the previously described contents will be omitted or briefly described.

The battery information obtaining step (S110) is a step of obtaining a resistance value and a voltage value of the battery, and may be performed by the data obtaining unit 110.

For example, the data obtaining unit 110 can obtain battery information about the voltage value and resistance value of the battery in real time. Depending on the embodiment, the data obtaining unit 110 may obtain battery information including the resistance value and voltage value measured through a voltage sensing line connected to the positive electrode and negative electrode of the battery. Additionally, the data obtaining unit 110 may be connected to a current sensor that measures the current of the battery. Also, the data obtaining unit 110 can obtain battery information from the current sensor through the current sensing line. The data obtaining unit 110 can obtain the resistance value and voltage value of the battery using information included in the battery information.

Depending on the embodiment, the data obtaining unit 110 may be configured to communicate with the outside. The data obtaining unit 110 can receive battery information including the voltage value and resistance value of the battery from the outside using communication.

In an embodiment, the data obtaining unit 110 may obtain the voltage value and resistance value at a time point when the battery remains in the idle state for a predetermined time after discharge ends. That is, the data obtaining unit 110 can obtain the voltage value and resistance value of the battery at a time point after a predetermined period of time while maintaining an idle state from the time point when discharge of the battery ends.

The profile generating step (S120) is a step of generating a profile representing the correspondence relationship between the resistance value and voltage value of the battery obtained in the battery information obtaining step (S110), and may be performed by the profile generating unit 120.

For example, the profile generating unit 120 and the data obtaining unit 110 may be connected wired and/or wirelessly to communicate with each other. Additionally, the profile generating unit 120 may receive battery information including the resistance value and voltage value from the data obtaining unit 110 through a wired line and/or a wireless communication network.

The profile generating unit 120 can generate a profile using the resistance value and voltage value of the battery obtained by the data obtaining unit 110. Here, the profile may represent the correspondence relationship between the resistance value and voltage value of the battery.

For example, the profile can be expressed as an X-Y two-dimensional graph when X is set to the voltage value of the battery and Y is set to the resistance value of the battery.

In an embodiment, the profile generating unit 120 can generate a profile if the voltage value belongs to a preset voltage section. The voltage section can be set based on a specific voltage value or based on a resistance reduction rate.

For example, the voltage section can be set under the condition where the reduction rate of resistance exceeds a preset threshold value as the voltage increases. In this case, the profile generating unit 120 can generate a profile if the reduction rate of resistance belongs to a section that exceeds the preset threshold value as the voltage increases.

The criterion range setting step (S130) is a step of setting a criterion range in the profile generated in the profile generating step, and may be performed by the control unit 130.

The control unit 130 can set a criterion range in the profile received from the profile generating unit 120. The criterion range may mean a range indicating that the change rate of the resistance value of the battery is normal.

For example, the control unit 130 can set the criterion range based on the criterion line. In an embodiment, the control unit 130 may set a criterion line indicating the change rate of the resistance value with respect to the voltage value in the profile. For example, the control unit 130 may set a criterion line by approximating a curve connecting each resistance value in the profile in which resistance values for voltage values are displayed.

In an embodiment, the plurality of criterion lines can be set in one profile according to the change rate of resistance value. For example, the control unit 130 can set a plurality of criterion lines in one profile based on a point where the change rate of resistance value changes rapidly.

In an embodiment, the control unit 130 may set the criterion range to be within a predetermined threshold value from the criterion line. For example, the control unit 130 may estimate a predetermined threshold value from the criterion line and set a criterion range within the predetermined threshold value.

Since the control unit 130 sets the criterion range to be within a predetermined threshold value from the criterion line, it is possible to prevent abnormal diagnosis due to minor errors occurring in the process of obtaining the resistance value and the voltage value of the battery.

In an embodiment, the control unit 130 may set a criterion range based on the plurality of criterion lines. For example, the control unit 130 may set a criterion range based on a plurality of criterion lines set for each section in which the change rate of resistance value changes rapidly.

Since the control unit 130 sets the criterion range based on different criterion lines set based on the point where the change rate of the resistance value changes rapidly, an abnormality can be more accurately diagnosed according to the resistance value of the battery.

The battery diagnosing step (S140) is a step of diagnosing whether an abnormality has occurred in the battery based on the result of comparing the resistance value of the battery and the criterion range, and may be performed by the control unit 130.

In an embodiment, the control unit 130 can diagnose whether an abnormality has occurred in the battery based on whether the resistance is outside the criterion range. For example, the control unit 130 can diagnose that no abnormality has occurred in the battery if the resistance value falls within the criterion range. Conversely, the control unit 130 can diagnose that an abnormality has occurred in the battery when the resistance value is outside the criterion range.

By diagnosing an abnormality using the result of the control unit 130 comparing the resistance value with the criterion range, the state of the battery can be diagnosed in a non-destructive manner.

The apparatus 100 for diagnosing a battery according to an embodiment of the present disclosure can specifically diagnose whether an abnormality has occurred in the battery by comparing the resistance value and criterion range of the battery.

The apparatus 100 for diagnosing a battery according to an embodiment of the present disclosure can accurately diagnose the state of the battery by generating a profile using the voltage value and resistance value measured in real time.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications. The scope of the disclosure is defined by the appended claims.

### (Explanation of reference signs)

1: battery pack
100: apparatus for diagnosing a battery
110: data obtaining unit
120: profile generating unit
130: control unit
140: storage unit
200: measuring unit
300: charging and discharging unit

## Claims

1. An apparatus (100) for diagnosing a battery, comprising
a data obtaining unit (110) configured to obtain a resistance value and a voltage value of a battery;
a profile generating unit (120) configured to generate a profile representing a correspondence relationship between the resistance value and the voltage value of the battery obtained by the data obtaining unit; and **characterised by**:
a control unit (130) configured to set a criterion range in the profile received from the profile generating unit and diagnose whether an abnormality has occurred in the battery based on the result of comparing the resistance value of the battery and the criterion range.

2. The apparatus for diagnosing a battery according to claim 1,
wherein the control unit is configured to set a criterion line representing a change rate of the resistance value with respect to the voltage value in the profile and set the criterion range based on the criterion line.

3. The apparatus for diagnosing a battery according to claim 2,
wherein the control unit is configured to set the criterion range within a predetermined threshold value from the criterion line.

4. The apparatus for diagnosing a battery according to claim 2,
wherein the control unit is configured to set the criterion line excluding a target resistance value and a target voltage value most recently included in the profile.

5. The apparatus for diagnosing a battery according to claim 1,
wherein the data obtaining unit is configured to obtain the voltage value and the resistance value at a time point when the battery remains in an idle state for a predetermined time after discharge ends, and
wherein the profile generating unit is configured to generate the profile when the voltage value belongs to a preset voltage section.

6. The apparatus for diagnosing a battery according to claim 5,
wherein the voltage section is set as a section where a reduction rate of resistance exceeds a preset threshold value as the voltage increases.

7. The apparatus for diagnosing a battery according to claim 1,
wherein the profile generating unit is configured to update the profile whenever the data obtaining unit obtains the resistance value and the voltage value, and
wherein the control unit is configured to set the criterion range whenever the profile is updated.

8. The apparatus for diagnosing a battery according to claim 1,
wherein the control unit is configured to diagnose whether an abnormality has occurred in the battery based on whether the resistance value is outside the criterion range.

9. The apparatus for diagnosing a battery according to claim 8,
wherein the control unit is configured to diagnose that no abnormality has occurred in the battery when the resistance value is within the criterion range, and to diagnose that an abnormality has occurred in the battery when the resistance value is outside the criterion range.

10. The apparatus for diagnosing a battery according to claim 1,
wherein when it is diagnosed that an abnormality has occurred in the battery, the control unit is configured to generate an alarm in response to the abnormality.

11. A battery pack (1), comprising the apparatus for diagnosing a battery according to any one of claims 1 to 10.

12. A method for diagnosing a battery, comprising:
a battery information obtaining step (S110) of obtaining a resistance value and a voltage value of a battery;
a profile generating step (S120) of generating a profile representing a correspondence relationship between the resistance value and the voltage value of the battery obtained in the battery information obtaining step; **characterised by**:
a criterion range setting step (S130) of setting a criterion range in the profile generated in the profile generating step; and
a battery diagnosing step (S140) of diagnosing whether an abnormality has occurred in the battery based on the result of comparing the resistance value of the battery and the criterion range.

## Patentansprüche

1. Vorrichtung (100) zum Diagnostizieren einer Batterie, umfassend:
eine Datenerhaltungseinheit (110), die konfiguriert ist, um einen Widerstandswert und einen Spannungswert einer Batterie zu erhalten;
eine Profilerzeugungseinheit (120), die konfiguriert ist, um ein Profil zu erzeugen, das eine Entsprechungsbeziehung zwischen dem Widerstandswert und dem Spannungswert der Batterie darstellt, die durch die Datenerhaltungseinheit erhalten wird; und **gekennzeichnet durch**:
eine Steuereinheit (130), die konfiguriert ist, um einen Kriteriumsbereich in dem Profil einzustellen, das von der Profilerzeugungseinheit empfangen wird, und zu diagnostizieren, ob eine Abnormalität in der Batterie aufgetreten ist, basierend auf dem Ergebnis des Vergleichens des Widerstandswerts der Batterie und des Kriteriumsbereichs.

2. Vorrichtung zum Diagnostizieren einer Batterie nach Anspruch 1,
wobei die Steuereinheit konfiguriert ist, um eine Kriteriumslinie einzustellen, die eine Änderungsrate des Widerstandswerts in Bezug auf den Spannungswert in dem Profil darstellt, und den Kriteriumsbereich basierend auf der Kriteriumslinie einzustellen.

3. Vorrichtung zum Diagnostizieren einer Batterie nach Anspruch 2,
wobei die Steuereinheit konfiguriert ist, um den Kriteriumsbereich innerhalb eines vorbestimmten Schwellenwerts von der Kriteriumslinie einzustellen.

4. Vorrichtung zum Diagnostizieren einer Batterie nach Anspruch 2,
wobei die Steuereinheit konfiguriert ist, um die Kriteriumslinie unter Ausschluss eines Zielwiderstandswerts und eines Zielspannungswerts, die zuletzt in dem Profil enthalten sind, einzustellen.

5. Vorrichtung zum Diagnostizieren einer Batterie nach Anspruch 1,
wobei die Datenerhaltungseinheit konfiguriert ist, um den Spannungswert und den Widerstandswert zu einem Zeitpunkt zu erhalten, wenn die Batterie für eine vorbestimmte Zeit nach Ende der Entladung in einem Ruhezustand bleibt, und
wobei die Profilerzeugungseinheit konfiguriert ist, um das Profil zu erzeugen, wenn der Spannungswert zu einem voreingestellten Spannungsabschnitt gehört.

6. Vorrichtung zum Diagnostizieren einer Batterie nach Anspruch 5,
wobei der Spannungsabschnitt als ein Abschnitt eingestellt ist, in dem eine Verringerungsrate des Widerstands einen voreingestellten Schwellenwert überschreitet, wenn die Spannung zunimmt.

7. Vorrichtung zum Diagnostizieren einer Batterie nach Anspruch 1,
wobei die Profilerzeugungseinheit konfiguriert ist, um das Profil immer dann zu aktualisieren, wenn die Datenerhaltungseinheit den Widerstandswert und den Spannungswert erhält, und
wobei die Steuereinheit konfiguriert ist, um den Kriteriumsbereich immer dann einzustellen, wenn das Profil aktualisiert wird.

8. Vorrichtung zum Diagnostizieren einer Batterie nach Anspruch 1,
wobei die Steuereinheit konfiguriert ist, um zu diagnostizieren, ob eine Abnormalität in der Batterie aufgetreten ist, basierend darauf, ob der Widerstandswert außerhalb des Kriteriumsbereichs liegt.

9. Vorrichtung zum Diagnostizieren einer Batterie nach Anspruch 8,
wobei die Steuereinheit konfiguriert ist, um zu diagnostizieren, dass keine Abnormalität in der Batterie aufgetreten ist, wenn der Widerstandswert innerhalb des Kriteriumsbereichs liegt, und zu diagnostizieren, dass eine Abnormalität in der Batterie aufgetreten ist, wenn der Widerstandswert außerhalb des Kriteriumsbereichs liegt.

10. Vorrichtung zum Diagnostizieren einer Batterie nach Anspruch 1,
wobei, wenn diagnostiziert wird, dass eine Abnormalität in der Batterie aufgetreten ist, die Steuereinheit konfiguriert ist, um einen Alarm als Reaktion auf die Abnormalität zu erzeugen.

11. Batteriepack (1), umfassend die Vorrichtung zum Diagnostizieren einer Batterie nach einem der Ansprüche 1 bis 10.

12. Verfahren zum Diagnostizieren einer Batterie, umfassend:
einen Batterieinformationserhaltungsschritt (S110) des Erhaltens eines Widerstandswerts und eines Spannungswerts einer Batterie;
einen Profilerzeugungsschritt (S120) des Erzeugens eines Profils, das eine Entsprechungsbeziehung zwischen dem Widerstandswert und dem Spannungswert der Batterie darstellt, die in dem Batterieinformationserhaltungsschritt erhalten wird **gekennzeichnet durch**:
einen Kriteriumsbereichseinstellschritt (S130) des Einstellens eines Kriteriumsbereichs in dem Profil, das in dem Profilerzeugungsschritt erzeugt wird; und
einen Batteriediagnoseschritt (S140) des Diagnostizierens, ob eine Abnormalität in der Batterie aufgetreten ist, basierend auf dem Ergebnis des Vergleichens des Widerstandswerts der Batterie und des Kriteriumsbereichs.

## Revendications

1. Appareil (100) de diagnostic d'une batterie, comprenant :
une unité d'obtention de données (110) configurée pour obtenir une valeur de résistance et une valeur de tension d'une batterie ;
une unité génératrice de profil (120) configurée pour générer un profil représentant une relation de correspondance entre la valeur de résistance et la valeur de tension de la batterie obtenues par l'unité d'obtention des données ; et
**caractérisé par** :
un module de commande (130) configuré pour définir une plage de critères dans le profil reçu de l'unité génératrice de profil et diagnostiquer si une anomalie s'est produite dans la batterie d'après le résultat de la comparaison entre la valeur de résistance de la batterie et la plage de critères.

2. Appareil de diagnostic d'une batterie selon la revendication 1,
le module de commande étant configuré pour définir une ligne de critères représentant un taux de variation de la valeur de résistance relativement à la valeur de tension dans le profil, et définir la plage de critères en fonction de la ligne de critères.

3. Appareil de diagnostic d'une batterie selon la revendication 2,
le module de commande étant configuré pour définir la plage de critères dans une valeur seuil prédéterminée d'après la ligne de critères.

4. Appareil de diagnostic d'une batterie selon la revendication 2,
le module de commande étant configuré pour définir la ligne de critères en excluant une valeur de résistance cible et une valeur de tension cible intégrées le plus récemment dans le profil.

5. Appareil de diagnostic d'une batterie selon la revendication 1,
l'unité d'obtention de données étant configurée pour obtenir la valeur de tension et la valeur de résistance en un point dans le temps où la batterie reste en état de veille pendant un temps prédéterminé après la fin de la décharge, et
l'unité génératrice de profil étant configurée pour générer le profil lorsque la valeur de tension appartient à une section de tension prédéfinie.

6. Appareil de diagnostic d'une batterie selon la revendication 5,
la section de tension étant définie comme une section où un taux de réduction de la résistance dépasse une valeur seuil prédéfinie au fur et à mesure de l'augmentation de la tension.

7. Appareil de diagnostic d'une batterie selon la revendication 1,
l'unité génératrice du profil étant configurée pour mettre à jour le profil chaque fois que l'unité d'obtention de données obtient la valeur de résistance et la valeur de tension, et
le module de commande étant configuré pour définir la plage de critères à chaque mise à jour du profil.

8. Appareil de diagnostic d'une batterie selon la revendication 1,
le module de commande étant configuré pour diagnostiquer si une anomalie s'est produite dans la batterie selon que la valeur de résistance se trouve hors de la plage de critères.

9. Appareil de diagnostic d'une batterie selon la revendication 8,
le module de commande étant configuré pour diagnostiquer qu'aucune anomalie ne s'est produite dans la batterie lorsque la valeur de résistance est comprise dans la plage de critères, et pour diagnostiquer qu'une anomalie s'est produite dans la batterie lorsque la valeur de résistance se trouve hors de la plage de critères.

10. Appareil de diagnostic d'une batterie selon la revendication 1,
dans lequel, s'il est diagnostiqué qu'une anomalie s'es produite dans la batterie, le module de commande est configuré pour générer une alarme en réponse à l'anomalie.

11. Bloc-batterie (1), comprenant l'appareil de diagnostic d'une batterie selon une quelconque des revendications 1 à 10.

12. Procédé de diagnostic d'une batterie, comprenant :
une étape d'obtention d'informations sur la batterie (S110) comportant l'obtention d'une valeur de résistance et d'une valeur de tension d'une batterie ;
une étape de génération de profil (S120) comportant la génération d'un profil représentant une relation de correspondance entre la valeur de résistance et la valeur de tension de la batterie, obtenues à l'étape d'obtention d'informations sur la batterie ;
**caractérisé par** :
une étape de définition d'une plage de critères (S130) comportant la définition d'une plage de critères dans le profil généré à l'étape de génération du profil ; et
une étape de diagnostic de la batterie (S140) pour diagnostiquer si une anomalie s'est produite dans la batterie d'après le résultat de la comparaison de la valeur de résistance de la batterie avec la plage de critères.
